# EUROPEAN PATENT APPLICATION

(11) **EP 4 553 885 A1**
(43) Date of publication of application: **14.05.2025**
(21) Application number: 23208804.7
(22) Date of filing: 09.11.2023
(51) Int. Cl.: H01J 37/07, H01J 37/06, H01J 37/18

(54) **SOURCE, ASSESSMENT APPARATUS, METHOD OF CLEANING A CHARGED PARTICLE SOURCE, METHOD OF CLEANING A COMPONENT OF AN ASSESSMENT APPARATUS**

(71) Applicant: ASML Netherlands B.V., 5500 AH Veldhoven (NL)
(72) Inventor: VAN SOEST, Jurgen, 5500 AH Veldhoven (NL)
(74) Representative: ASML Netherlands B.V.

(57) **Abstract**

The present disclosure relates to a charged particle source and related apparatus and methods. In one arrangement, the source comprises a first emitter element configured to emit assessment charged particles, an extractor configured to accelerate the emitted assessment charged particles towards a sample, and one or more second emitter elements configured to emit cleaning charged particles. The source is configured to cause the cleaning charged particles to impinge intermittently on a target surface during a corresponding plurality of cleaning periods.

## Description

### FIELD

The embodiments provided herein generally relate to apparatus for generating and directing charged particles such as electrons towards a sample and related apparatus and methods.

### BACKGROUND

When manufacturing semiconductor integrated circuit (IC) chips, undesired pattern defects may occur on a substrate (e.g. wafer) or a mask during the fabrication processes, thereby reducing the yield. Defects may occur as a consequence of, for example, optical effects and incident particles or other processing steps such as etching, deposition or chemical mechanical polishing. Monitoring the extent of the undesired pattern defects is therefore an important process in the manufacture of IC chips. More generally, the inspection and/or measurement of a surface of a substrate, or other object/material, is an important process during and/or after its manufacture.

Pattern assessment systems for example pattern inspection tools with a charged particle beam have been used to assess objects, for example to detect pattern defects. These tools typically use electron microscopy techniques, such as a scanning electron microscope (SEM). In an exemplary SEM design, a primary electron beam of electrons at a relatively high energy is targeted with a final deceleration step to land on a target at a relatively low landing energy. The beam of electrons is focused as a probing spot on the target. The interactions between the material structure at the probing spot and the landing electrons from the beam of electrons cause electrons to be emitted from the surface, such as secondary electrons, backscattered electrons or Auger electrons, which together may be referred as signal electrons or more generally signal particles. The generated secondary electrons may be emitted from the material structure of the target.

By scanning the primary electron beam as the probing spot over the target surface, signal electrons can be emitted across the surface of the target. By collecting these emitted signal electrons from the target surface, a pattern inspection tool (or apparatus) may obtain an image-like signal representing characteristics of the material structure of the surface of the target. In such inspection the collected signal electrons are detected by a detector within the apparatus. The detector generates a signal in response to the incident charged particles. As an area of the sample is inspected, the signals comprise data which is processed to generate the inspection image corresponding to the inspected area of the sample.

Electrons forming the primary electron beam are generated by a source. In some implementations, the source comprises a cold field emitter. To counteract high frequency instability, cold field emitters are typically operated at extreme high vacuum. Flashing may be used to periodically remove contaminants from an emitter tip (e.g., a tungsten tip). Flashing involves temporarily increasing the temperature of the emitter tip. A downside of flashing is that the tip may be deformed slightly by each application of high temperature, meaning that performance may be progressively degraded. The flashing process also requires downtime, both for the flashing itself and for column alignment steps that may be needed afterwards. It is possible to reduce these issues by flashing more frequently at lower temperatures (mild-flashing), but the issues may not be fully overcome.

Systems using charged particles generally need to operate in good vacuum. Outgassing makes it difficult to achieve and maintain high vacuum. Outgassing contaminants may include gasses such as water and hydrocarbons. Such outgassing contaminants may be continually released from such features unless countermeasures are implemented. A bake-out process may be used to encourage outgassing of contaminants prior to use, for example from features of the source. Outgassed contaminants can be pumped away during the bake-out process. The bake-out process involves temporarily increasing a temperature of components that can contribute to outgassing, for example to around 120 degrees Celsius. Increasing the temperature increases the rate of outgassing. Despite efforts such as performing a bake-out process, a significant pressure increase is typically still observed when an electron beam is turned on for the first time due to electron stimulated desorption (ESD). ESD involves molecules being dislodged from surfaces by incoming electrons and by localized heating caused by the electron beam. The increase in pressure caused by ESD can damage the source and/or lead to temporary shutdown of a source until the pressure falls to safe levels. ESD is maximal when the source is first turned on but can remain relatively high for many hours or even days. Surfaces hit directly by the primary beam are cleaned rapidly but other surfaces are only hit by backscattered and secondary electrons and for these surfaces the cleaning rate is much lower. The challenge is also exacerbated by contaminants condensing back onto surfaces from the gaseous state. It is also noted that the bake-out process itself can be very lengthy, for example involving several days of downtime.

### SUMMARY

It is an object of the present disclosure to at least partially address the issues mentioned above, for example to improve cleaning of an emitter element of a source and/or to improve processing to reduce outgassing during use of a charged particle-optical device.

According to an aspect of the invention, there is provided a source configured to emit a beam of charged particles towards a sample, the source for an assessment apparatus for assessing the sample by projecting the beam of charged particles towards the sample, the source comprising: a first emitter element configured to emit assessment charged particles; an extractor configured to accelerate the emitted assessment charged particles towards a sample; and one or more second emitter elements configured to emit cleaning charged particles, wherein: the source is configured to cause the cleaning charged particles to impinge intermittently on a target surface of the assessment apparatus during a corresponding plurality of cleaning periods.

According to an aspect of the invention, there is provided a method of cleaning a charged particle source of an assessment apparatus, the source comprising a first emitter element and one or more second emitter elements, the method comprising: using the first emitter element to emit assessment charged particles and project a beam of charged particles comprising the assessment charged particles towards a sample to assess the sample; and using the one or more second emitter elements to emit cleaning charged particles and causing the cleaning charged particles to impinge intermittently on a target surface of the assessment apparatus during a corresponding plurality of cleaning periods.

According to an aspect of the invention, there is provided a method of cleaning a component of an assessment apparatus for assessing a sample by projecting a beam of charged particles towards the sample, wherein: the assessment apparatus comprises: a source comprising a first emitter element configured to emit a beam of assessment charged particles towards a sample for assessment of the sample; a charged particle-optical device configured to project the beam of assessment charged particles from the source towards the sample; and a vacuum chamber configured to contain at least the charged particle-optical device and the source, wherein: the method comprises causing cleaning charged particles emitted from one or more second emitter elements to impinge on a component of the assessment apparatus while: the component is at a pressure higher than 10⁻¹⁰ mbar; and/or a pressure within the vacuum chamber is above an assessment pressure at which the charged particle-optical device is configured to project the beam of charged particles towards the sample for assessing the sample.

Advantages of embodiments of the present disclosure will become apparent from the following description taken in conjunction with the accompanying drawings wherein are set forth, by way of illustration and example, certain embodiments of the present disclosure.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary assessment apparatus.
**FIG. 2** is a schematic diagram illustrating an exemplary single-beam charged particle-optical device that is part of the exemplary assessment apparatus of **FIG. 1****.**
**FIG. 3** is a schematic diagram illustrating an exemplary multi-beam charged particle-optical device that is part of the exemplary assessment apparatus of **FIG. 1****.**
**FIG. 4** is a schematic diagram of an exemplary charged particle-optical device comprising a collimator element array and a scan-deflector array that is part of the exemplary assessment apparatus of **FIG. 1****.**
**FIG. 5** is a schematic diagram of a source comprising first and second emitter elements.
**FIG. 6** is a graph depicting an example cleaning control signal.
**FIG. 7** is a graph depicting an example assessment control signal.
**FIG. 8** depicts steps in an example method of cleaning a component of an assessment system.

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

### DETAILED DESCRIPTION

The reduction of the physical size of devices, and enhancement of the computing power of electronic devices, may be accomplished by significantly increasing the packing density of circuit components such as transistors, capacitors, diodes, etc. on an IC chip. This has been enabled by increased resolution enabling yet smaller structures to be made. Semiconductor IC manufacturing is a complex and time-consuming process, with hundreds of individual steps. An error in any step of the process of manufacturing an IC chip has the potential to adversely affect the functioning of the final product. Just one defect could cause device failure. It is desirable to improve the overall yield of the process. For example, to obtain a 75% yield for a 50-step process (where a step may indicate the number of layers formed on a wafer), each individual step must have a yield greater than 99.4%. If an individual step has a yield of 95%, the overall process yield would be as low as 7-8%.

Maintaining a high substrate (i.e. wafer) throughput, defined as the number of substrates processed per hour, is also desirable. High process yield and high substrate throughput may be impacted by the presence of a defect. This is especially true if operator intervention is required for reviewing the defects. High throughput detection and identification of micro and nano-scale defects by assessment systems (such as a Scanning Electron Microscope ('SEM')) is desirable for maintaining high yield and low cost for IC chips.

A scanning electron microscope comprises a scanning device and a detector apparatus. The scanning device comprises an illumination apparatus that comprises an electron source, for generating primary electrons, and a projection apparatus for scanning a target, such as a substrate, with one or more focused beams of primary electrons. The primary electrons interact with the target and generate interaction products, such as signal particles e.g. secondary electrons and/or backscattered electrons. Secondary electrons may be considered to have an energy of up to 50eV. Backscatter electrons, although having an energy spectrum from substantially zero to the energy of the maximum of the charged particle device, are conventionally set to electrons (or signal electrons) having an energy exceeding 50eV. The detection apparatus captures the signal particles (e.g. secondary electrons and/or backscattered electrons) from the target as the target is scanned so that the scanning electron microscope may create an image of the scanned area of the target. A design of charged particle-optical apparatus embodying these scanning electron microscope features may have a single beam. For higher throughput such as for assessment, some designs of apparatus use multiple focused beams, i.e. a multi-beam, of primary electrons. The component beams of the multi-beam may be referred to as sub-beams or beamlets. A multi-beam may scan different parts of a target simultaneously. A multi-beam assessment apparatus may therefore assess a target much quicker, e.g. by moving the target at a higher speed, than a single-beam assessment apparatus.

The figures are schematic. Relative dimensions of components in drawings are therefore exaggerated for clarity. While the description and drawings are directed to an electron-optical apparatus, it is appreciated that the embodiments are not used to limit the present disclosure to specific charged particles. References to electrons, and items referred to with reference to electrons, throughout the present document may therefore be more generally considered to be references to charged particles, and items referred to with reference to charged particles may be understood as encompassing, but not necessarily requiring, the charged particles to be electrons.

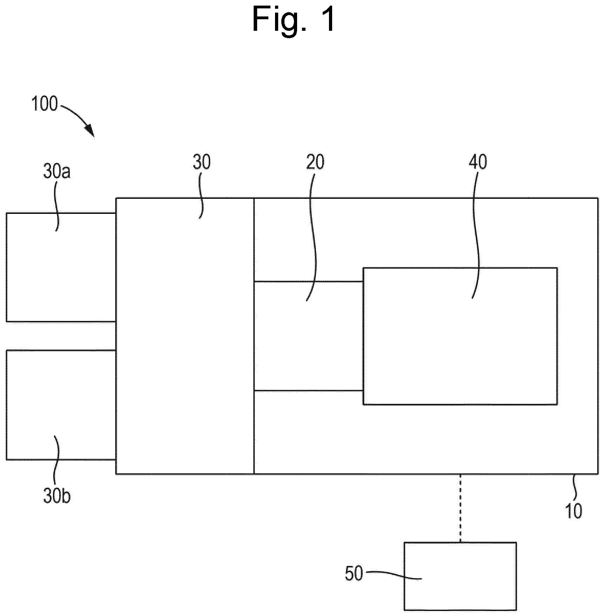

Reference is now made to **FIG. 1****,** which is a schematic diagram illustrating an exemplary assessment apparatus 100, or inspection apparatus. The assessment apparatus 100 of **FIG. 1** includes a vacuum chamber 10, a load lock chamber 20, a charged particle-optical apparatus, an equipment front end module (EFEM) 30 and a controller 50. The charged particle-optical apparatus may be within the vacuum chamber 10. The charged particle-optical apparatus may comprise a charged particle-optical device 40 (also known as an electron-optical device, an electron beam device or an electron beam device) and a motorized or actuated stage.

The EFEM 30 includes a first loading port 30a and a second loading port 30b. The EFEM 30 may include additional loading port(s). The first loading port 30a and second loading port 30b may, for example, receive substrate front opening unified pods (FOUPs) that contain substrates (e.g., semiconductor substrates or substrates made of other material(s)) or targets to be assessed (substrates, wafers and samples are collectively referred to as "targets" hereafter). One or more robot arms (not shown) in EFEM 30 transport the targets to load lock chamber 20.

The load lock chamber 20 is used to remove the gas around a target. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. The main chamber 10 is connected to a main chamber vacuum pump system (not shown). The main chamber vacuum pump system removes gas molecules in the main chamber 10 so that the pressure around the target reaches a second pressure lower than the first pressure. After reaching the second pressure, the target is transported to the charged particle-optical device 40 by which it may be assessed. A charged particle-optical device 40 may comprise either a single-beam or a multi-beam charged particle-optical device 40.

The controller 50 is electronically connected to the charged particle-optical device 40. The controller 50 may be a processor (such as a computer) configured to control the charged particle beam assessment apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam assessment apparatus or it may be distributed over at least two of the component elements. While the present disclosure provides examples of main chamber 10 housing an electron beam assessment apparatus, it should be noted that aspects of the disclosure in their broadest sense are not limited to a chamber housing a charged particle-optical device. Rather, it is appreciated that the foregoing principles may also be applied to other apparatuses and other arrangements of apparatus that operate under the second pressure.

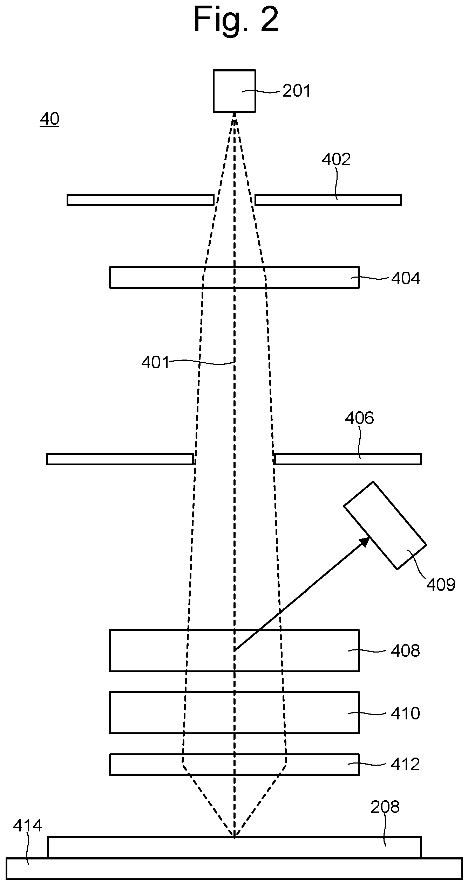

Reference is now made to **FIG. 2****,** which is a schematic diagram of an exemplary single-beam charged particle-optical device 40 of an assessment apparatus, e.g. the assessment apparatus 100 of **FIG. 1****.** The charged particle-optical device 40 may comprise an electron source 201, a gun aperture plate 402 (or a current limiting aperture), a condenser lens 404, a beam-limit aperture plate 406, a beam separator 408, a deflection scanning unit 410, an objective lens 412, and a sample support 414.

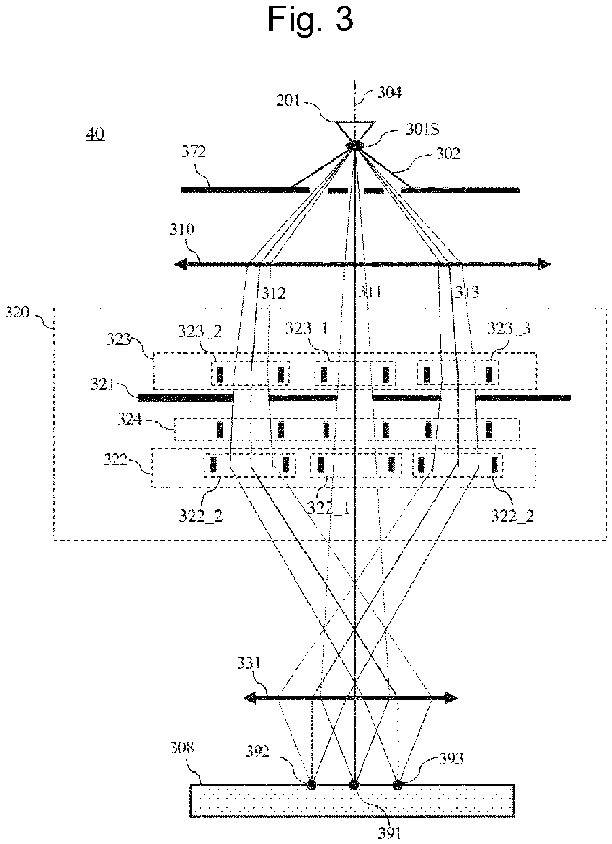

The source 201 provides electrons forming a primary electron beam 401. Example implementation details for the source 201 are described in further detail below. The source 201 may, for example, be implemented as described below with reference to **FIG. 3****.** The gun aperture 402 blocks peripheral electrons of the primary electron beam 201 to reduce the Coulomb effect.

The condenser lens 404 is configured to apply a focusing effect to the primary electron beam 401. The beam-limit aperture plate 406 is configured to limit a size of the primary electron beam 401. An electric current of primary electron beam 401 can be varied by adjusting a focusing power of the condenser lens 404 or by changing a radial size of the beam-limit aperture 406.

The objective lens 412 focusses the primary electron beam 401 onto a sample 208 to be inspected. The primary electron beam 401 can form a probe spot on a surface of the sample 208. Interaction between the probe spot and the sample 208 generates signal electrons (e.g., secondary electrons and/or backscattered electrons). The signal electrons propagate through the objective lens 412 to the beam separator 408. The beam separator 408 redirects the signal electrons towards a detector 409. The detector 409 detects the signal electrons and generates a corresponding signal. The beam separator 408 may comprise a Wien filter configured to use crossed electric and magnetic fields to redirect the signal electrons while allowing the primary beam 401 to pass undeflected.

The deflection scanning unit 410 is configured to scan the probe spot over the surface of the sample 208. The sample support 414 supports the sample 208 and may be referred to as a stage. The sample support 414 may be motorized. The sample support 414 may move to allow the probe spot to be scanned over a larger region of the sample 208 than is possible using only the deflection scanning unit 414.

Reference is now made to **FIG. 3****,** which is a schematic diagram of an exemplary multi-beam charged particle-optical device 40 of an assessment apparatus, e.g. the assessment apparatus 100 of **FIG. 1****.** The charged particle-optical device 40 may comprise an electron source 201, a beam former array 372 (also known as a gun aperture plate, a coulomb aperture array or a pre-sub-beam-forming aperture array), a condenser lens 310, a source converter (or micro-optical array) 320, an objective lens 331, and a target 308. In an embodiment the condenser lens 310 is magnetic. The target 308 may be supported by a support on a stage. The stage may be motorized. The stage moves so that the target 308 is scanned by the incident electrons. The electron source 201, the beam former array 372, the condenser lens 310 may be the components of an illumination apparatus comprised by the charged particle-optical device 40. The source converter 320 (also known as a source conversion unit), described in more detail below, and the objective lens 331 may be the components of a projection apparatus comprised by the charged particle-optical device 40.

The electron source 201, the beam former array 372, the condenser lens 310, the source converter 320, and the objective lens 331 are aligned with a primary electron-optical axis 304 of the charged particle-optical device 40. The electron source 201 may generate a primary beam 302 generally along the electron-optical axis 304 and with a source crossover (virtual or real) 301S. The electron source 201 may comprise an emitter and one or both of an extractor and an anode. During operation, the emitter of the electron source 201 is configured to emit electrons. The electrons are extracted or accelerated by the extractor and/or the anode to form the primary beam 302.

The beam former array 372 cuts the peripheral electrons of primary electron beam 302 to reduce a consequential Coulomb effect. The primary-electron beam 302 may be trimmed into a specified number of sub-beams, such as three sub-beams 311, 312 and 313, by the beam former array 372. It should be understood that the description is intended to apply to a charged particle-optical device 40 with any number of sub-beams such as one, two or more than three. The beam former array 372, in operation, is configured to block off peripheral electrons to reduce the Coulomb effect.

The source converter 320 is configured to convert the beam (including sub-beams if present) transmitted by the beam former array 372 into the sub-beams that are projected towards the target 308. In an embodiment the source converter is a unit. Alternatively, the term source converter may be used simply as a collective term for the group of components that form the beamlets from the sub-beams.

As shown in **FIG. 3****,** in an embodiment the charged particle-optical device 40 comprises a beam-limiting aperture array 321 with an aperture pattern (i.e. apertures arranged in a formation) configured to define the outer dimensions of the beamlets (or sub-beams) projected towards the target 308. In an embodiment the beam-limiting aperture array 321 is part of the source converter 320. In an alternative embodiment the beam-limiting aperture array 321 is part of the system upbeam of the main device. In an embodiment, the beam-limiting aperture array 321 divides one or more of the sub-beams 311, 312, 313 into beamlets such that the number of beamlets projected towards the target 308 is greater than the number of sub-beams transmitted through the beam former array 372. In an alternative embodiment, the beam-limiting aperture array 321 keeps the number of the sub-beams incident on the beam-limiting aperture array 321, in which case the number of sub-beams may equal the number of beamlets projected towards the target 308.

As shown in **FIG. 3****,** in an embodiment the charged particle-optical device 40 comprises a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams 311, 312, and 313 onto the beam-limiting aperture array 321.

The charged particle-optical device 40 may also include an image-forming element array 322 with image-forming deflectors 322_1, 322_2, and 322_3. There is a respective deflector 322_1, 322_2, and 322_3 associated with the path of each beamlet. The deflectors 322_1, 322_2, and 322_3 are configured to deflect the paths of the beamlets towards the electron-optical axis 304. The deflected beamlets form virtual images (not shown) of source crossover 301S. In the current embodiment, these virtual images are projected onto the target 308 by the objective lens 331 and form probe spots 391, 392, 393 thereon. The charged particle-optical device 40 may also include an aberration compensator array 324 configured to compensate aberrations that may be present in each of the sub-beams. In an embodiment the aberration compensator array 324 comprises a lens configured to operate on a respective beamlet. The lens may take the form or an array of lenses. The lenses in the array may operate on a different beamlet of the multi-beam. The aberration compensator array 324 may, for example, include a field curvature compensator array (not shown) for example with micro-lenses. The field curvature compensator and micro-lenses may, for example, be configured to compensate the individual sub-beams for field curvature aberrations evident in the probe spots, 391, 392, and 393. The aberration compensator array 324 may include an astigmatism compensator array (not shown) with micro-stigmators. The micro-stigmators may, for example, be controlled to operate on the sub-beams to compensate astigmatism aberrations that are otherwise present in the probe spots, 391, 392, and 393.

The image-forming element array 322, the aberration compensator array 324, and the pre-bending deflector array 323 may comprise multiple layers of sub-beam manipulating devices, some of which may be in the form of arrays, for example: micro-deflectors, micro-lenses, or micro-stigmators. Beam paths may be manipulated rotationally. Rotational corrections may be applied by a magnetic lens. Rotational corrections may additionally, or alternatively, be achieved by an existing magnetic lens such as the condenser lens arrangement.

The objective lens 331 focuses the beamlets onto the surface of the target 308, i.e., it projects the three virtual images onto the target surface. The three images formed by three sub-beams 311 to 313 on the target surface form three probe spots 391, 392 and 393 thereon. In an embodiment the deflection angles of sub-beams 311 to 313 are adjusted to pass through or approach the front focal point of objective lens 331 to reduce or limit the off-axis aberrations of three probe spots 391 to 393. In an arrangement the objective lens 331 is magnetic. Although three beamlets are mentioned, this is by way of example only. There may be any number of beamlets.

In an embodiment a beam separator (not shown) is provided. The beam separator may be downbeam of the source converter 320. The beam separator may be, for example, a Wien filter comprising an electrostatic dipole field and a magnetic dipole field. The beam separator may be upbeam of the objective lens 331. In operation, the beam separator may be configured to exert an electrostatic force by electrostatic dipole field on individual electrons of sub-beams. In an embodiment, the electrostatic force is equal in magnitude but opposite in direction to the magnetic force exerted by the magnetic dipole field of beam separator on the individual primary electrons of the sub-beams. The sub-beams may therefore pass at least substantially straight through the beam separator with at least substantially zero deflection angles. The direction of the magnetic force depends on the direction of motion of the electrons while the direction of the electrostatic force does not depend on the direction of motion of the electrons. So because the secondary electrons and backscattered electrons (or signal electrons) generally move in an opposite direction compared to the primary electrons, the magnetic force exerted on the secondary electrons and backscattered electrons (or signal particles) will no longer cancel the electrostatic force and as a result the secondary electrons and backscattered electrons moving through the beam separator will be deflected away from the electron-optical axis 304.

In an embodiment a secondary device (not shown) is provided comprising detection elements for detecting corresponding secondary charged particle beams. On incidence of secondary beams with the detection elements, the elements may generate corresponding intensity signal outputs. The outputs may be directed to an image processing system (e.g., controller 50). Each detection element may comprise an array which may be in the form of a grid. The array may have one or more pixels; each pixel may correspond to an element of the array. The intensity signal output of a detection element may be a sum of signals generated by all the pixels within the detection element.

In an embodiment a secondary projection apparatus and its associated electron detection device (not shown) are provided. The secondary projection apparatus and its associated electron detection device may be aligned with a secondary electron-optical axis of the secondary device. In an embodiment the beam separator is arranged to deflect the path of the secondary electron beams towards the secondary projection apparatus. The secondary projection apparatus subsequently focuses the path of secondary electron beams onto a plurality of detection regions of the electron detection device. The secondary projection apparatus and its associated electron detection device may register and generate an image of the target 308 using the secondary electrons or backscattered electrons (or signal particles).

Such a Wien filter, a secondary device and/or a secondary projection apparatus may be provided in a single beam assessment apparatus. Additionally and/or alternatively a detection device may be present downbeam of the objective lens, for example facing the sample during operation. In an alternative arrangement a detector device is position along the path of the charged particle beam towards the sample. Such an arrangement does not have a Wien filter, a secondary device and a secondary projection apparatus. The detection device may be positioned at one or more positions along the path of the charged particle beam path towards the sample, such as facing the sample during operation, for example around the path of the charged particle beam. Such a detector device may have an aperture and may be annular. The different detector devices may be positioned along the path of the charged particle to detect signal particles having different characteristics. The electron-optical elements along the path of the charged particle beam, which may include one or more electrostatic plates with an aperture for the path of the charged particle beam, may be arranged and controlled to focus the signal particles of different respective characteristics to a respective detector device at different positions along the path of charged particle beams. Such electrostatic plates may be arranged in series of two or more adjoining plates along the path of the charged particle beam.

Any element or collection of elements may be replaceable or field replaceable within the charged particle-optical device. The one or more electron-optical components in the charged particle-optical device, especially those that operate on sub-beams or generate sub-beams, such as aperture arrays and manipulator arrays may comprise one or more plates each of which may be an electrode or may comprise one or more electrodes per aperture of the array. Such a plate may be manufactured using processing suitable for manufacturing microelectromechanical systems (MEMS); such a charged particle-optical component or device may be referred to as a MEMS. MEMS are miniaturized mechanical and electromechanical elements that are made using microfabrication techniques. The pre-bending deflector array 323 may be a MEMS. In an embodiment the charged particle-optical device 40 comprises apertures, lenses and deflectors which may be formed as MEMS. In an embodiment, the manipulators such as the lenses and deflectors 322_1, 322_2, and 322_3 are controllable, passively, actively, as a whole array, individually or in groups within an array, so as to control the beamlets of charged particles projected towards the target 308.

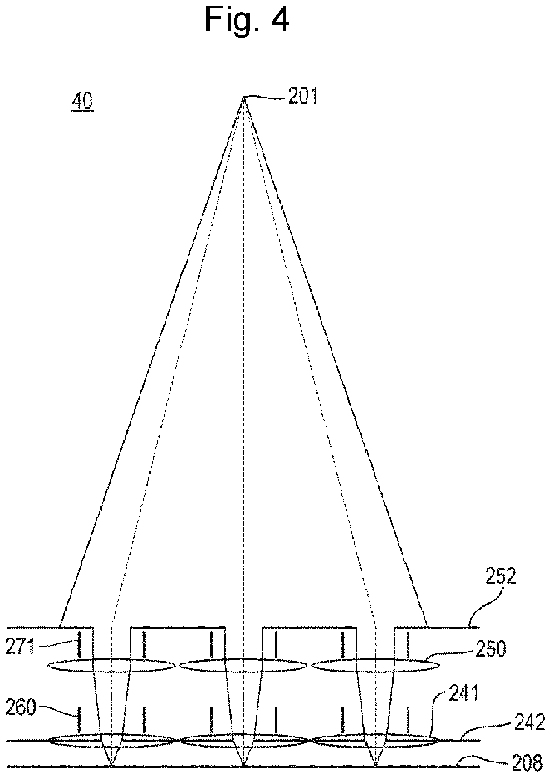

In an embodiment the charged particle-optical device 40 may comprise alternative and/or additional components on the charged particle path, such as lenses and other components some of which have been described earlier with reference to **FIG. 1-3****.** Examples of such arrangements are shown in **FIG. 4** which are described in further detail later. A detector is provided to detect charged particles emitted by the sample. The detector may be integrated into the objective lens. The detector may be on the bottom surface of the objective lens so as to face a sample in use. Additionally or alternatively the detector may be positioned at the upbeam portion, or upbeam, of the objective lens array. The detector may comprise an array, for example of detector elements, which may correspond to the array of the beamlets of the multi-beam arrangement. The detectors (or detector elements) in the detector array may generate detection signals that may be associated with the pixels of a generated image. The condenser lenses, objective lenses and/or detector may be formed as MEMS or CMOS devices.

**FIG. 4** is a schematic diagram of another design of an exemplary charged particle-optical device 40. The charged particle-optical device 40 may comprise a source 201 and one or more electron-optical assemblies. Alternatively, the electron-optical apparatus that comprises the charged particle-optical device 40 may comprise the source 201. The charged particle-optical device 40 may comprise an upper beam limiter 252, a collimator element array 271, a control lens array 250, a scan deflector array 260, an objective lens array 241, a beam shaping limiter 242 and a detector array. The source 201 provides a beam of charged particles (e.g. electrons).

The upper beam limiter 252 defines an array of beam-limiting apertures. The upper beam limiter 252 forms the sub-beams from the beam of charged particles emitted by the source 201.

The collimator element array 271 is provided downbeam of the upper beam limiter 252. Each collimator element collimates a respective sub-beam. In another arrangement, the collimator may take the form, wholly or partially, of a macro-collimator. Such a macro-collimator may be upbeam of the upper beam limiter 252 so it operates on the beam from the source before generation of the multi-beam. A magnetic lens may be used as the macro-collimator.

Down-beam of the collimator element array there is the control lens array 250. The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 may be considered as providing electrodes additional to the electrodes 242, 243 of the objective lens array 241. The additional electrodes of the control lens array 250 allow further degrees of freedom for controlling the electron-optical parameters of the sub-beams.

For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. As described above, lens arrays may instead comprise multiple plates with apertures.

The scan-deflector array 260 comprising a plurality of scan deflectors may be provided. The scan-deflector array 260 may be formed using MEMS manufacturing techniques. Each scan deflector scans a respective sub-beam over the sample 208. In an embodiment, the scanning deflectors described in EP2425444, which document is hereby incorporated by reference in its entirety specifically in relation to scan deflectors, may be used to implement the scan-deflector array 260.

The objective lens array 241 comprising a plurality of objective lenses is provided to direct the sub-beams onto the sample 208. Each objective lens comprises at least two electrodes (e.g. two or three electrodes) connected to respective potential sources.

The objective lens array may form part of an objective lens array assembly along with any or all of the scan-deflector array 260, control lens array 250 and collimator element array 271. The objective lens array assembly may further comprise the beam shaping limiter 242. The beam shaping limiter 242 defines an array of beam-limiting apertures. The beam shaping limiter 242 may be structurally integrated with an electrode 302 of the objective lens array 241. Desirably, the beam shaping limiter 242 is positioned in a region of low electrostatic field strength. Each of the beam-limiting apertures is aligned with a corresponding objective lens in the objective lens array 241.

An electric power source may be provided to supply power to all components of the charged particle optical device, such as currents to electron-magnetic components and potentials to electrostatic elements. For example the power source may apply respective potentials to electrodes of any of the electron-optical components such as lenses such as control lenses of the control lens array 250 and the objective lenses of the objective lens array 241.

In an embodiment, a charged particle-optical device array is provided. The array may comprise a plurality of any of the charged particle-optical devices described herein. Each of the charged particle-optical devices focuses respective multi-beams simultaneously onto different regions of the same sample. Any number of charged particle-optical devices may be used in the array. Each charged particle-optical device in the array 500 be configured in any of the ways described herein when referring to a single charged particle-optical device, for example as described above. Details of such an arrangement is described in US 2023/0238215 A1 which, with respect to how the objective lens is incorporated and adapted for use in the multi-device arrangement is hereby incorporated by reference.

An alternative design of multi-beam charged particle-optical device may have the same features as described with respect to **FIG. 4** except with a condenser lens array provided upbeam of the objective lens array , as disclosed in EP 3 869 535 A1 which is hereby incorporated by reference so far as the description of the multi-beam device with a collimator and its components.

As mentioned in the introductory part of the description, contaminants can cause damage to a charged particle source such as an electron source. Periodic heating may be used to remove such contaminants but prior art approaches for implementing such heating can progressively degrade a source tip and/or require significant downtime. Heating of an emitter for cold field emission requires time both to heat the emitter and to allow the emitter to cool down again. Embodiments disclosed below at least partly address these issues.

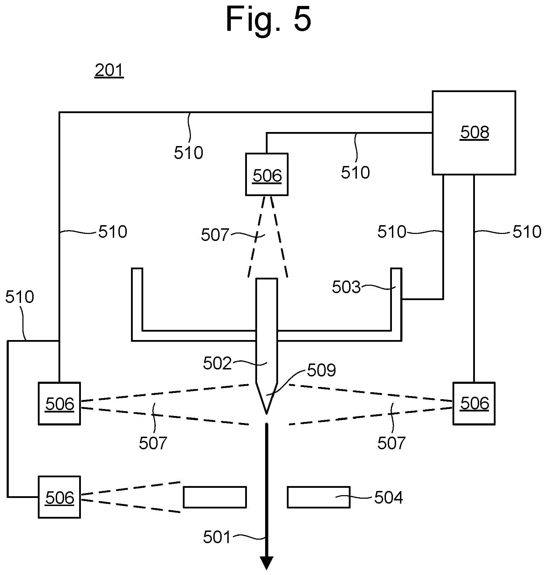

**FIG. 5** depicts an embodiment of a charged particle source 201. The source 201 is configured to emit a beam of charged particles 501 (e.g., an electron beam such as primary electron beam 401 in **FIG. 2**) towards a sample 208. The source 201 may form part of an assessment apparatus 100 for assessing the sample 208 by projecting the beam of charged particles 501 towards the sample 208. The assessment apparatus 100 may take any number of forms such as those described above with reference to **FIG. 1-4****.** The assessment apparatus 100 may comprise a charged particle-optical device 40 configured to project the beam of charged particles 501 from the source 201 towards the sample 208. The charged particle-optical device 40 may take any of the forms described above with reference to **FIG. 2-4****.** The assessment apparatus 100 may comprise a sample support 414 as described above with reference to **FIG. 2****.** The assessment apparatus 100 may comprise a vacuum chamber 10 as described above with reference to **FIG. 1****.** (Although reference is made to the source 201 separate from the charged particle device 40, in a different arrangement the source 201 may be part of the charged particle device 40).

The source 201 comprises an emitter for emitting the beam of charged particles 501 which are used for the electron beam of the primary electron beam. For convenience herein such an emitter is referred to as a first emitter element 502. The first emitter element 502 may, for example, comprise a tungsten body having a tapered tip. The tungsten body may be referred to as a tungsten tip. The first emitter element 502 may be held in a desired position by a mounting arrangement 503. The mounting arrangement 503 may be electrically connected to the first emitter element 502 to allow an electrical potential to be applied to the first emitter element 502 via the mounting arrangement 503. The first emitter element 502 is configured to emit assessment charged particles (e.g., electrons). The assessment charged particles are charged particles that are used to assess (e.g., inspect) the sample 208 by impinging on the sample 208 and generating signal charged particles that are detected and analyzed to obtain information about the sample 208 as described above. The assessment charged particles form the beam of charged particles 501.

The first emitter element 502 may comprise a tip region 509. The tip region 509 may comprise a portion of the first emitter element 502 that is closest to the sample 208. The tip region 509 may be tapered, as depicted schematically in **FIG. 5****.** The tip region 509 may be tapered in a direction towards the sample 208. The tip region 509 may point towards the sample 208.

The source 201 comprises an extractor 504. The extractor 504 is configured to accelerate the emitted assessment charged particles towards the sample 208 (i.e., in a downwards direction in the orientation shown in **FIG. 5****).** The extractor 504 may comprise an electrode with an aperture to allow the beam of charged particles 501 to pass through the extractor 504 towards the sample 208.

The source 201 may be configured to operate the first emitter element 502 as a field emission source. The tip region 509 may be tapered to a sufficiently sharp point that field emission occurs when an electric field is applied between the first emitter element 502 and the extractor 504. In an arrangement, the tip region 509 may be shaped to permit the emission of electrons during operation, for example by effectively lowering the local electric field around the tip. Except where explicitly stated otherwise, in any of the embodiments described herein the first emitter element 502 may be operated as a cold field emitter. In such embodiments, the first emitter element 502 may comprise a bare tungsten tip. In a cold field emitter, field emission (or field induced emission) is the dominant or only significant mechanism by which charged particles (e.g., electrons) are emitted from the first emitter element 502. In such embodiments, the first emitter element 502 is not therefore heated (e.g. actively heated for example with a separate heating element) during emission of the assessment charged particles. The first emitter element 502 may be operated at room temperature or may even be cooled to below room temperature. Except where explicitly stated otherwise, any of the embodiments described herein may operate the first emitter element 502 as a Schottky emitter, where emission of charged particles is driven by a combination of heating and field induced emission. In such embodiments, the first emitter element 502 may comprise a coated tungsten tip, for example a tungsten tip coated with for example zirconium oxide, Cerium boride (e.g. CeB₆) or Lanthanum Boride (e.g. LaB₆,) or a tip formed from for example CeB₆ or LaB₆, for example as a single crystal.

The source 201 comprises one or more second emitter elements 506. In the example of **FIG. 5****,** four second emitter elements 506 are provided. Each second emitter element emits cleaning charged particles 507 (e.g., electrons). The cleaning charged particles and assessment charged particles may be the same type of charged particles (e.g., electrons), with "cleaning" and "assessment" being labels to help to distinguish between them in the present text. Such second emitter elements may be referred to or considered as secondary emitter elements such as cleaning emitter elements.

The cleaning charged particles are used to clean a target surface of the assessment apparatus 100. The target surface may be in the source 201 or elsewhere in the assessment apparatus 100. In the particular exemplary arrangement of **FIG. 5****,** four second emitter elements are depicted, although in other arrangements there may be as many or as few second emitter elements in a source featuring such emitter elements as may be desired. Three second emitter elements 506 are configured to direct cleaning charged particles towards the first emitter element 502 (from different directions). One second emitter element 506 is configured to direct cleaning charged particles towards the extractor 504. Bombarding a surface with charged particles such as electrons is known to apply a cleaning function to the surface. The cleaning charged particles may interact with particles (e.g., molecules) on the surface to cause them to leave the surface, for example via excitation or decomposition. In the case of electrons, this process may be referred to as electron stimulated desorption (ESD). If desired, it is possible to tune the process to achieve a useful degree of electron stimulated desorption without significantly heating the surface being cleaning. The process may be tuned for example by selecting appropriate values of a potential difference between the second emitters and the target surface, of a current of cleaning charged particles, and of a duration and/or frequency of application. By reducing or avoiding heating of the surface being cleaning it is possible to reduce or avoid damage to the surface being cleaning, such as deformation of a sharp tip of a cold field emitter.

The source 201 may be configured to operate one or more of the second emitter elements 506 in a higher current mode than the first emitter element 502. One or more of the second emitter elements 506 may for example comprise an emission material such as CeB₆, LaB₆ (e.g., as a layer such as a coating or as a single crystal) or a dispenser cathode. The dispenser cathode may, for example, comprise a porous metal matrix (e.g., tungsten) impregnated with an emission enhancing material such as BaO, CaO and/or Al₂O₃. In some embodiments, the first emitter element 502 is operated as a cold field emitter and the second emitter element 506 (or second emitter elements 506) may be operated as a different type of emitter such as a Schottky emitter.

The source 201 may comprise a controller 508. The controller 508 may be configured to control one or more components of the source 201. In the example shown, control lines 510 are provided between the controller 508 and the first emitter element 502 and the respective second emitter elements 506. The controller 508 may thereby control operation of the first emitter element 502 and the respective second emitter elements 506. The controller 508 may be configured to controllably apply an electrical potential (voltage) to the first emitter element 502 and the second emitter elements 506. The controller 508 may comprise any suitable combination of hardware, firmware and/or software for achieving this functionality, including for example suitably programmed data processing hardware (e.g., processor(s), memory, data storage, buses, etc.). The controller 508 may be configured to interact with one or more power supplies to provide the required electrical potentials and/or may comprise one or more power supplies. (Note: where reference is made to a plurality of second emitters, it is intended such disclosure encompasses arrangements in which a single second emitter is present).

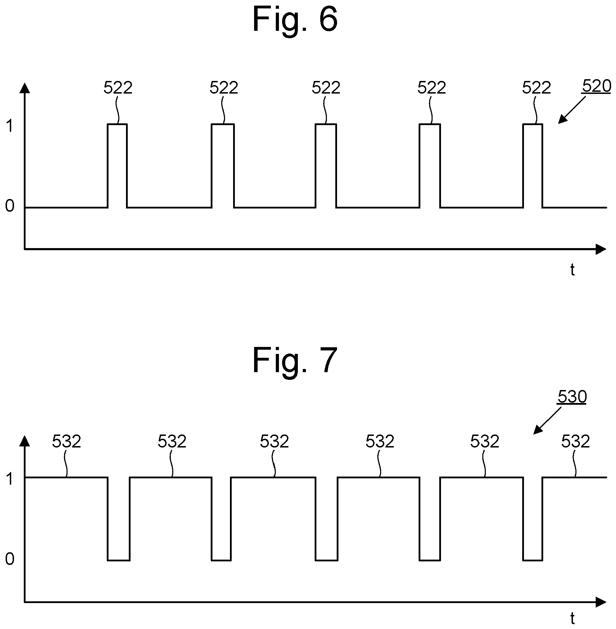

Referring to **FIG. 6****,** the source 201 is configured, for example by suitable programming of the controller 508, to cause the cleaning charged particles to impinge intermittently on a target surface of the source 201 during a corresponding plurality of cleaning periods 522. The correspondence between the cleaning periods 522 and the intermittent nature of the impingement of the cleaning charged particles on the target surface arises because the timing of the cleaning periods 522 defines when the impingement of the cleaning charged particles occurs. A sequence of cleaning periods 522 may be defined by a cleaning control signal 520. An example cleaning control signal 520 is shown in **FIG. 6****,** where the vertical axis represents a value of the cleaning control signal and the horizontal axis represents time (t). In this example, a value of "1" in the cleaning control signal 520 corresponds to a cleaning process corresponding to a cleaning period 522 being active. A value of "0" in the cleaning control signal 520 corresponds to the cleaning process being inactive.

The target surface of the source 201 may include a portion of the first emitter element 502. The target surface may comprise the tip region 509 of the first emitter element 502. In an embodiment, the first emitter element 502 defines an emitting surface for example of electrons for the primary electron beam. The emitting surface is part of a surface of the first emitter element 502. The source 201 is configured to cause the assessment charged particles to be emitted from the emitting surface. The emitting surface may be in the tip region 509 of the first emitter element 502 (e.g., including a sharpest portion of the tip region where field emission is strongest). The target surface to be cleaned may comprise at least a portion of the emitting surface. Alternatively or additionally, as exemplified in **FIG. 5****,** the target surface may comprise a surface of the source 201 outside of the emitting surface, such as a surface of: the extractor 504 and/or anode; any further electrode present in the source (not shown); a surface of one more mountings for the extractor, anode and/or further electrode; and/or a surface of any other element of the source exposed to the vacuum within the source such as the interior surface of the housing of the source (not shown); and/or a surface associated with implementing any of the second emitter elements 506, such as a mounting or housing (not shown) for the second emitter element 506. It is desirable to clean surfaces outside of the emitting surface because such surfaces can contribute to outgassing and therefore to undesirable deposition of contaminants on the emitting surface.

In an embodiment, the source 201 is configured, for example by suitable programming of the controller 508, to apply a potential difference between the first emitter element 502 and the or each of the one or more second emitter elements 506. The potential difference may be applied at least during the cleaning periods. The potential difference may be such as to drive the cleaning charged particles towards at least a portion of the first emitter element 502. The potential difference may be controlled such that a potential of the second emitter element 506 is made more negative than a potential of the first emitter element during the cleaning periods 522.

Referring to **FIG. 7****,** in an embodiment the source 201 is configured, for example by suitable programming of the controller 508, to cause the assessment charged particles to be accelerated intermittently towards the sample 208 during a corresponding plurality of assessment periods 532. The correspondence between the assessment periods 532 and the intermittent nature of the acceleration of the assessment charged particles arises because the timing of the assessment periods 522 defines when the assessment charged particles are accelerated towards the sample 208. A sequence of assessment periods 532 may be defined by an assessment control signal 530. An example assessment control signal 530 is shown in **FIG. 7****,** where the vertical axis represents a value of the assessment control signal and the horizontal axis represents time (t). In this example, a value of "1" in the assessment control signal corresponds to an assessment process corresponding to an assessment period 532 being active. A value of "0" in the assessment control signal corresponds to the assessment process being inactive.

The assessment periods 532 are separate from the cleaning periods 522, for example starting and/or ending at different times. The assessment periods 532 may be arranged to be non-overlapping with the cleaning periods 522, as exemplified in **FIG. 6** and **7****.** In some embodiments, as further exemplified in **FIG. 6** and **7****,** the source 201 is configured, for example by suitable programming of the controller 508, to interleave the cleaning periods 522 with the assessment periods 532. In the example shown, each assessment period 532 begins when a preceding cleaning period 522 ends and ends when a subsequent cleaning period 522 begins. In an alternative implementation, a delay may be provided between the end of each cleaning period 522 and the beginning of the next subsequent assessment period 532 and/or between the end of each subsequent assessment period 532 and the beginning of the next subsequent cleaning period 522. Durations of the cleaning periods may be the same (as shown in **FIG. 6****)** or may vary. Durations of the assessment periods may be the same (as shown in **FIG. 7****)** or may vary. It should be noted that the operation regimes for operating the second emitter elements 506 for cleaning and for operating the first emitter 502 for assessment as depicted in **FIGs 6** and **7** are exemplary. Any operational regime may be selected, desirably without the cleaning occurring during times of sample assessment. Such assessment may occur when signal electrons generated by the primary beam are detected for generation of data e.g. an image for sample assessment. However, the cleaning may be implemented during times of sample assessment if desired. The cleaning charged particles may, for example, be arranged to have higher energy than the assessment charged particles and can be separated on this basis from the assessment charged particles (e.g., kept separate from the primary beam or primary beams).

In an embodiment, the target surface comprises a surface in the charged particle-optical device 40. The surface may, for example, be a portion of a charged particle-optical element of the charged particle-optical device 40, such as a portion of one or more of a gun aperture plate 402, a condenser lens 404, a beam-limit aperture plate 406, a beam separator 408, a deflection scanning unit 410, and an objective lens 412. In such an arrangement one or more of the second emitter elements 506 may be positioned within the charged particle-optical device 40, for example proximate the target surface within the charged particle-optical device 40. The cleaning charged particles can thus be used to clean a range of different components in the assessment apparatus 100. It may be useful, for example, to clean any component that is exposed to an interior region of the vacuum chamber 10. It is desirable to minimize outgassing from any such component to achieve or maintain high vacuum in the vacuum chamber 10.

In an embodiment, the charged particle-optical device 40 is configured to operate on the beam of charged particles 501 to cause the beam of charged particles 501 to scan over a surface of the sample 208. In such an embodiment, the assessment apparatus 100 may be configured such that the cleaning periods 522 are interleaved between scanning of different portions of the surface of the sample 208 by the beam of charged particles. The different portions of the surface of the sample 208 may for example be different scanning lines, for example each different scanning line being an electrostatic scanning line in which the relative motion of the beam and the sample is actuated by an electron-optical component of the charged particle optical device 40 such as a scan deflector. In a different example, the scanning line is achieved by relative actuation of the sample by a mechanical actuator of the support and an electron-optical component of the charged particle optical device 40 such as a scan deflector. (For example the scanning line may be achieved with the sample static or actuated by the sample support). In the example of **FIG. 6** and **7****,** each assessment period 532 may for example correspond to scanning of a different respective scanning line.

In some embodiments, the source 201 is configured to drive each of one or more of the second emitter elements 506 to emit charged particles exclusively during the cleaning periods 522. This may reduce or avoid cleaning electrons contributing to outgassing (e.g., via ESD) during the assessment periods.

Alternatively, the source 201 may be configured to drive each of one or more of the second emitting elements 506 to emit charged particles during the cleaning periods 522 and during the assessment periods 532. In embodiments of this type, the source 201 may be configured to control an electric field between each of the second emitter elements 506 and the target surface such that the cleaning charged particles emitted from the second emitter element 506 are accelerated towards the target surface exclusively during the cleaning periods. The electric field may be controlled, for example, by switching a potential of the second emitter element 506. The potential of the second emitter element 506 may be switched to be more negative than a potential of the target surface during the cleaning periods 522. The potential of the second emitter element 506 may be switched to be less negative than the potential of the target surface during the assessment periods 532. Controlling the electric field to switch between causing the cleaning charged particles to impinge on the target surface and not causing the cleaning charged particles to impinge on the target surface can be done quickly.

The cleaning process can thus be switched on and off quickly. It is not necessary to wait for elements to heat up or cool down. Downtime due to cleaning can thus be minimized. For example, the cleaning periods could be arranged to be of the order of microseconds, for example less than about 50 microseconds, optionally less than about 20 microseconds, optionally less than about 10 microseconds, optionally less than about 5 microseconds, optionally less than about 1 microsecond, optionally less than about 500 nanoseconds, optionally less than about 250 nanoseconds, optionally less than about 120 microseconds. Making the cleaning periods small may facilitate integration of the cleaning periods into scanning procedures for scanning charged particles over the sample 208 during assessment of the sample 208. For example, cleaning periods may be interleaved between scanning of different scanning lines on the sample 208, as mentioned above. Making the cleaning periods small also reduces or removes the risk of destabilization of the first emitter element 502 during the cleaning periods. It is not therefore expected that there will be any significant contribution to downtime from needing to wait for stabilization of the beam of charged particles used for assessing the sample 208.

In an embodiment, at least a portion of the target surface is in a direct line of sight of one or more of the second emitter elements 506. Arranging for a portion of the target surface to be in a direct line of sight promotes efficient cleaning of the portion of the target surface by the cleaning charged particles. The cleaning charged particles can impinge directly onto the portion of the target surface, thereby efficiently dislodging contaminants and/or locally heating the target surface. Portions of the target surface that are not in direct line of sight may be cleaned for example by conduction of the localized heating and/or by impingement of secondary or backscattered charged particles generated by impingement of the cleaning charged particles onto the portion of the target surface that is in direct line of sight of the respective second emitter element 506.

The source 201 may be configured, for example by suitable programming of the controller 508, such that one or more of the cleaning periods is while a pressure at the first emitter element 502 is at an assessment pressure. The assessment pressure may be lower than 10⁻⁹ mbar, optionally lower than 10⁻¹⁰ mbar, optionally lower than 10⁻¹¹ mbar, optionally of the order of or lower than 10⁻¹² mbar. Alternatively or additionally, when the source 201 is configured to operate the first emitter element 502 as a cold field emitter, the assessment pressure may be defined as any pressure suitable for operating the cold field emitter. The assessment pressure may for example be in the range of about 10⁻¹¹ mbar to about 10⁻¹³ mbar, desirably lower than about 10⁻¹² mbar.

As mentioned in the introductory part of the description, outgassing from components within a vacuum chamber work against achieving and maintaining high vacuum levels. Bake out processes may be performed prior to operation of an assessment apparatus 100 to reduce outgassing. Bake out processes involve heating elements to temperatures that are above their normal operating temperatures. Such heating causes an elevated rate of outgassing, which reduces the amount of adsorbed material on the component. Outgassing from the component after the component has returned to a normal operating temperature will be lower than if the bake out had not been performed.

A shortcoming of bake out processing is that it is time consuming. Embodiments described herein provide improved cleaning relative to a normal bake out process by using the one or more second emitter elements 506 to clean components by impinging charged particles onto the components, for example causing ESD and/or localized heating. As described below, the one or more second emitter elements 506 can be configured to endure higher pressures than the first emitter element 502 and/or be used in a sacrificial mode. Second emitter elements may be referred to as operating in a sacrificial mode because in this mode of operation the second emitter elements are allowed to degrade over time. In this mode of operation the second emitter elements may be replaced when necessary, for example periodically. An emitter element operated under a sacrificial mode may be referred to as a sacrificial emitter. The one or more second emitter elements 506 can be configured to endure higher pressures than the first emitter element 502 by being of different type to the first emitter element 502. For example, the first emitter element 502 may be configured to operate as a cold field emitter, which will typically require a very high vacuum level to operate (e.g., of the order of 10⁻¹² mbar) while the one or more second emitter elements 506 may comprise an emission material such as a CeB₆, LaB₆,. In an arrangement one or more of the second emitter elements 506 may be a dispenser cathode. Such a dispenser cathode can withstand significantly higher pressures (e.g., up to of the order of 10⁻⁶ mbar).

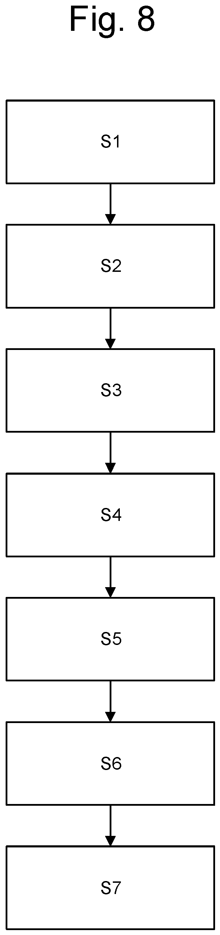

In some embodiments, arranging for the one or more second emitter elements 506 to endure higher pressures than the first emitter element 502, and/or to be used in a sacrificial mode is exploited for cleaning; that is to operate the second emitter elements 506 at higher operating pressures than that of the first emitter element 502 is exploited or used for cleaning. During such exploitation a cleaning operation may be started earlier in a pump down operation than would otherwise be possible, for example by turning on or at least operating the second emitter elements 506 earlier in a pump down operation as described below with reference to **FIG. 8****.** Operating the second emitter element 506 before pump down is complete means the vacuum pressure is higher than normal operating pressures for such an emitter element Thus operating a second emitter element 506 in such an environment risks reducing the lifetime of the second emitter element 506; however this is at the benefit of a faster cleaning operation. Alternatively or additionally, the cleaning operation using the second emitter elements 506 may be combined with a bake out operation. The cleaning operation may thereby improve the efficacy of the bake out operation. Such a cleaning operation may reduce a needed length of the bake out operation, and/or reduce a required frequency of bake out operations.

In comparison with a standard bake out operation, the cleaning operation using the second emitter elements 506 may be directed preferentially to regions where cleaning is most important. Such regions may include components that are more likely to be subject to ESD from assessment charged particles during assessment of a sample 208. Alternatively or additionally, such regions may include surfaces that are otherwise hard to reach surfaces. The cleaning charged particles from the second emitter elements 506 may clean surfaces by directly impinging on those surfaces (e.g., causing ESD and/or localized heating). Alternatively or additionally, the cleaning charged particles from the second emitter elements 506 may clean surfaces by causing heating of those surfaces by conduction from a nearby impingement surface. Such cleaning by conduction may be used for example to clean ceramic parts adjacent to charged particle-optical elements of the charged particle-optical device 40. Because such cleaning can be applied locally in a highly selective manner, the cleaning may be performed without significantly heating components of the source 201 (e.g., a casing of the source and/or surrounding elements). In some implementations, the source 201 may be further protected from unwanted heating by providing thermal barriers and cooling mechanisms (e.g., water cooling). Such thermal barriers, insulation and cooling mechanisms may be integrated into the element being thermally managed by such barriers, insulation and cooling mechanisms. Such a cooling mechanism may be a cooling fluid conduit, The conduit may be in contact with the element for thermal conditioning by the cooling fluid element. In an arrangement the conduit may be within the element for thermal conditioning.

In some embodiments, one or more of the second emitter elements 506 may be detachably connected to the source 201. This facilitates exchange of the second emitter elements 506 should the second emitter elements 506 become damaged. This may occur, for example, when the second emitter elements 506 are operated at an elevated vacuum pressure, such as during a bake-out process or early during a pump down process. The elevated vacuum pressure is elevated relative to (i.e., is higher than) an assessment pressure. The assessment pressure is a pressure at which the assessment apparatus 100 is configured to project the beam of charged particles towards the sample 208 for assessing the sample 208. When operated at such elevated vacuum pressures, a lifetime of a second emitter element 506 may be reduced, for example significantly. In some embodiments, one or more of the second emitter elements 506 may be specifically configured to operate at elevated vacuum pressures.

Thus, in some embodiments, the source 201 is configured, for example by suitable programming of the controller 508, such that one or more of the cleaning periods 522 is while a pressure at the first emitter element 502 is above the assessment pressure, for example during a bake-out process or during pumping down of the assessment apparatus. The pressure above the assessment pressure may, for example, be above 10⁻¹⁰ mbar, optionally above 10⁻⁹ mbar, optionally above 10⁻⁸ mbar, optionally above 10⁻⁷ mbar, optionally above 10⁻⁶ mbar, optionally above 10⁻⁵ mbar.

As described above, the cleaning charged particles may impinge on a target surface that is part of the source 201, such as an emitting surface of the first emitter element 502 or a surface of the source 201 outside of the emitter surface. Alternatively or additionally, the cleaning charged particles may be directed to impinge on other components of the assessment apparatus, such as on a component of the charged particle-optical device 40, such as a charged particle-optical element or component of any of the charged particle-optical devices 40 described above with reference to **FIG. 2-4** (e.g., gun aperture plate 402, condenser lens 404, beam-limit aperture plate 406, beam separator 408, deflection scanning unit 410, objective lens 412, etc.). The impingement cleans (e.g., via ESD) and/or locally heats the components. Locally heating the components may clean the components by increasing a rate of outgassing and/or reducing or preventing net deposition of contaminants onto the components.

**FIG. 8** depicts an example implementation of a method of the disclosure in which cleaning charged particles emitted from one or more second emitter elements 506 are caused to impinge on a component of the assessment apparatus 100. In this implementation, the component may be part of the source 201 or part of a charged particle-optical device 40 as described above. The method is arranged such that the impingement occurs while the component is at a pressure higher than 10⁻¹⁰ mbar (for example the assessment pressure). The method may be arranged such that the impingement occurs while a pressure within the vacuum chamber is above an assessment pressure at which the charged particle-optical device 40 is configured to project the beam of charged particles towards the sample 208 for assessing the sample 208.

At step S1 of the example method, a pumping down of the vacuum chamber 10 from a starting pressure is started. The starting pressure may be a pressure of the environment outside the assessment apparatus 100 (e.g., substantially ambient or atmospheric pressure). The starting pressure is higher than the assessment pressure. The pressure in the vacuum chamber 10 is monitored during the pumping down of the vacuum chamber 10.

At step S2 of the method, an initiation pressure is detected. The initiation pressure is between the starting pressure and the assessment pressure.

At step S3 of the method, impingement of cleaning charged particles on a component of the assessment apparatus 100 is initiated in response to the pressure reaching the initiation pressure, as detected in step S2. After initiation cleaning of the component (or at least a target region of the component) is started by using one more second emitter elements.

At step S4 of the method, the pumping down process is continued in parallel with the impingement of cleaning charged particles on the component of the assessment apparatus 100. The pressure in the vacuum chamber 10 continues to be monitored. During this step the cleaning of the component continues. Operation of the second emitter element is continued to achieve cleaning.

At step S5 of the method, a stopping pressure is detected. The stopping pressure may be between the initiation pressure and the assessment pressure or may be substantially equal to the assessment pressure.

At step S6 of the method, impingement of cleaning charged particles on the component of the assessment apparatus 100 is stopped in response to the pressure reaching the stopping pressure, as detected in S5. The operation of the second emitter is stopped. On stopping of the impingement of the cleaning beam generated by the second emitter, cleaning of a component undergoing cleaning is stopped.

At step S7 of the method, optionally after pumping the vacuum chamber 10 to an even lower pressure than the stopping pressure, an assessment process of the sample 208 is initiated. The assessment process comprises projecting a beam of charged particles 501 onto the sample 208. The beam of charged particles 501 is formed from charged particles emitted by the first emitter element 502 of the source 201.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided the following clauses:
Clause 1. A source configured to emit a beam of charged particles towards a sample, the source for an assessment apparatus for assessing the sample by projecting the beam of charged particles towards the sample, the source comprising: a first emitter element configured to emit assessment charged particles; an extractor configured to accelerate the emitted assessment charged particles towards a sample; and one or more second emitter elements configured to emit cleaning charged particles, wherein: the source is configured to cause the cleaning charged particles to impinge intermittently on a target surface of the assessment apparatus during a corresponding plurality of cleaning periods.
Clause 2. The source of clause 1, wherein the source is configured to cause the assessment charged particles to be accelerated intermittently towards the sample during a corresponding plurality of assessment periods, the assessment periods being separate from the cleaning periods.
Clause 3. The source of clause 2, wherein the source is configured to interleave the cleaning periods with the assessment periods.
Clause 4. The source of clause 2 or 3, wherein the source is configured to drive each of one or more of the second emitter elements to emit charged particles exclusively during the cleaning periods.
Clause 5. The source of clause 2 or 3, wherein the source is configured to drive each of one or more of the second emitting elements to emit charged particles during the cleaning periods and during the assessment periods.
Clause 6. The source of clause 5, wherein the source is configured to control an electric field between the second emitter element and the target surface such that the cleaning charged particles emitted from the second emitter element are accelerated towards the target surface exclusively during the cleaning periods.
Clause 7. The source of clause 6, wherein the electric field is controlled by applying a potential difference between the second emitter element and the target surface such that a potential of the second emitter element is: more negative than a potential of the target surface during the cleaning periods; and less negative than the potential of the target surface during the assessment periods.
Clause 8. The source of any preceding clause, wherein at least a portion of the target surface is in a direct line of sight of one or more of the second emitter elements.
Clause 9. The source of any preceding clause, wherein the first emitter element defines an emitting surface, the source being configured to cause the assessment charged particles to be emitted from the emitting surface.
Clause 10. The source of clause 9, wherein the target surface comprises at least a portion of the emitting surface.
Clause 11. The source of clause 9 or 10, wherein the target surface comprises a surface of the source outside of the emitting surface, desirably said surface of the source consisting of a material liable to outgas.
Clause 12. The source of any preceding clause, configured to operate the first emitter element as a field emission source, optionally a cold field emitter or a Schottky emitter.
Clause 13. The source of any preceding clause, configured to operate one or more of the secondary emitter elements in a higher current mode than the first emitter element.
Clause 14. The source of any preceding clause, wherein one or more of the second emitter elements comprises an emission material such as CeB₆ or LaB₆, or a dispenser cathode.
Clause 15. The source of any preceding clause, wherein the one or more second emitter elements comprises a plurality of the second emitter elements.
Clause 16. The source of any preceding clause, wherein one or more of the second emitter elements is detachably connected, desirably being a sacrificial element or sacrificial elements, and/or is configured to operate at an elevated vacuum pressure relative to an assessment pressure at the first emitter element at which the assessment apparatus is configured to project the beam of charged particles towards the sample for assessing the sample.
Clause 17. The source of any preceding clause, configured such that one or more of the cleaning periods is while a pressure at the first emitter element is above an assessment pressure at which the assessment beam apparatus is configured to project the beam of charged particles towards the sample for assessing the sample.
Clause 18. The source of clause 17, wherein the pressure above the assessment pressure is above 10⁻¹⁰ mbar.
Clause 19. The source of clause 18, configured such that one or more of the cleaning periods is while the vacuum chamber is being baked out and/or pumped down.
Clause 20. The source of any preceding clause, configured such that one or more of the cleaning periods is while a pressure at the first emitter element is at an assessment pressure at which the assessment apparatus is configured to project the beam of charged particles towards the sample for assessing the sample.
Clause 21. The source of clause 20, wherein the assessment pressure is lower than 10⁻¹⁰mbar.
Clause 22. The source of any preceding clause, configured to apply a potential difference between the first emitter element and the or each of the one or more second emitter elements, at least during the cleaning periods, the potential difference being such as to drive the cleaning charged particles towards at least a portion of the first emitter element.
Clause 23. An assessment apparatus for assessing a sample by projecting a beam of charged particles towards the sample, the assessment apparatus comprising: the source of any of clauses 1 to 22; a sample support configured to support the sample; a charged particle-optical device configured to project the beam of charged particles from the source towards the sample; and a vacuum chamber containing at least the charged particle-optical device and the source.
Clause 24. The apparatus of clause 23, wherein the target surface comprises a surface in the charged particle-optical device, optionally a surface of a charged particle-optical element of the charged particle-optical device.
Clause 25. The apparatus of clause 23 or 24, wherein: the charged particle-optical device is configured to operate on the beam of charged particles to cause the beam of charged particles to scan over a surface of the sample; and the apparatus is configured such that the cleaning periods are interleaved between scanning of different portions of the surface of the sample by the beam of charged particles, optionally wherein the different portions of the surface of the sample are different scanning lines.
Clause 26. A method of cleaning a charged particle source of an assessment apparatus, the source comprising a first emitter element and one or more second emitter elements, the method comprising: using the first emitter element to emit assessment charged particles and project a beam of charged particles comprising the assessment charged particles towards a sample to assess the sample; and using the one or more second emitter elements to emit cleaning charged particles and causing the cleaning charged particles to impinge intermittently on a target surface of the assessment apparatus during a corresponding plurality of cleaning periods.
Clause 27. The method of clause 26, further comprising using the first emitter element to emit assessment charged particles and accelerating the assessment charged particles intermittently towards the sample during a corresponding plurality of assessment periods, the assessment periods being separate from the cleaning periods.
Clause 28. The method of clause 27, wherein the cleaning periods are interleaved with the assessment periods.
Clause 29. The method of clause 27 or 28, wherein each of one or more of the second emitter elements emit charged particles exclusively during the cleaning periods.
Clause 30. The method of clause 27 or 28, wherein each of one or more of the second emitting elements emit charged particles during the cleaning periods and during the assessment periods.
Clause 31. The method of clause 30, wherein an electric field between the second emitter element and the target surface is controlled such that the cleaning charged particles emitted from the second emitter element are accelerated towards the target surface exclusively during the cleaning periods.
Clause 32. The method of clause 31, wherein the electric field is controlled by applying a potential difference between the second emitter element and the target surface such that a potential of the second emitter element is: more negative than a potential of the target surface during the cleaning periods; and less negative than the potential of the target surface during the assessment periods.
Clause 33. The method of any of clauses 26 to 32, wherein at least a portion of the target surface is in a direct line of sight of one or more of the second emitter elements.
Clause 34. The method of any of clauses 26 to 33, wherein the assessment charged particles are emitted from an emitting surface of the first emitter element.
Clause 35. The method of clause 34, wherein the target surface comprises at least a portion of the emitting surface.
Clause 36. The method of clause 34 or 35, wherein the target surface comprises a surface of the source outside of the emitting surface, desirably said surface of the source consisting of a material liable to outgas.
Clause 37. The method of any of clauses 26 to 36, wherein the first emitter element is operated as a field emission source, optionally a cold field emitter or a Schottky emitter.
Clause 38. The method of any of clauses 26 to 37, wherein the second emitter elements are operated in a higher current mode than the first emitter element.
Clause 39. The method of any of clauses 26 to 38, wherein one or more of the second emitter elements comprises CeB₆, LaB₆, or a dispenser cathode.
Clause 40. The method of any of clauses 26 to 39, wherein the one or more second emitter elements comprises a plurality of the second emitter elements.
Clause 41. The method of any of clauses 26 to 40, comprising detaching and replacing one or more of the second emitter elements.
Clause 42. The method of any of clauses 26 to 41, wherein: the beam of charged particles comprising the assessment charged particles is projected towards the sample while the first emitter element is at an assessment pressure; and a pressure at the first emitter element is above the assessment pressure during one or more of the cleaning periods.
Clause 43. The method of clause 42, wherein the pressure above the assessment pressure is above 10⁻¹⁰ mbar.
Clause 44. The method of clause 43, wherein one or more of the cleaning periods is while the vacuum chamber is being baked out and/or pumped down.
Clause 45. The method of any of clauses 26 to 44, wherein: the beam of charged particles comprising the assessment charged particles is projected towards the sample while the first emitter element is at an assessment pressure; and a pressure at the first emitter element is at the assessment pressure during one or more of the cleaning periods.
Clause 46. The method of clause 45, wherein the assessment pressure is lower than 10⁻¹⁰ mbar.
Clause 47. The method of any of clauses 26 to 46, comprising applying a potential difference between the first emitter element and the or each of the one or more second emitter elements, at least during the cleaning periods, the potential difference being such as to drive the cleaning charged particles towards at least a portion of the first emitter element.
Clause 48. The method of any of clauses 26 to 47, wherein: the assessment apparatus comprises a charged particle-optical device configured to project the beam of charged particles from the source towards the sample; and the target surface comprises a surface in the charged particle-optical device, optionally a surface of a charged particle-optical element of the charged particle-optical device.
Clause 49. The method of any of clauses 26 to 48, comprising interleaving the cleaning periods between scanning of different portions of the surface of the sample by the beam of charged particles, optionally wherein the different portions of the surface of the sample are different scanning lines.
Clause 50. A method of cleaning a component of an assessment apparatus for assessing a sample by projecting a beam of charged particles towards the sample, wherein: the assessment apparatus comprises: a source comprising a first emitter element configured to emit a beam of assessment charged particles towards a sample for assessment of the sample; a charged particle-optical device configured to project the beam of assessment charged particles from the source towards the sample; and a vacuum chamber configured to contain at least the charged particle-optical device and the source, wherein: the method comprises causing cleaning charged particles emitted from one or more second emitter elements to impinge on a component of the assessment apparatus while: the component is at a pressure higher than 10⁻¹⁰ mbar; and/or a pressure within the vacuum chamber is above an assessment pressure at which the charged particle-optical device is configured to project the beam of charged particles towards the sample for assessing the sample.
Clause 51. The method of clause 50, comprising pumping down the vacuum chamber from a starting pressure to the assessment pressure, wherein the causing cleaning charged particles to impinge on the component occurs between the starting pressure and the assessment pressure, desirably initiating the causing cleaning charged particles to impinge on the component in response to the pressure reaching an initiation pressure, desirably the initiation pressure being between the starting pressure and the assessment pressure.
Clause 52. The method of clause 50 or 51, wherein the component of the assessment apparatus comprises: a component in the source, optionally an emitting surface of the first emitter element; and/or a component in the charged particle-optical device, optionally a charged particle-optical element.
Clause 53. The method of clause 52, wherein the cleaning particles are used to locally heat the component and thereby perform a local bake out of the component.

## Claims

**1.** A source configured to emit a beam of charged particles towards a sample, the source for an assessment apparatus for assessing the sample by projecting the beam of charged particles towards the sample, the source comprising:
a first emitter element configured to emit assessment charged particles;
an extractor configured to accelerate the emitted assessment charged particles towards a sample; and
one or more second emitter elements configured to emit cleaning charged particles, wherein:
the source is configured to cause the cleaning charged particles to impinge intermittently on a target surface of the assessment apparatus during a corresponding plurality of cleaning periods.

**2.** The source of claim 1, wherein the source is configured to cause the assessment charged particles to be accelerated intermittently towards the sample during a corresponding plurality of assessment periods, the assessment periods being separate from the cleaning periods.

**3.** The source of claim 2, wherein the source is configured to interleave the cleaning periods with the assessment periods.

**4.** The source of claim 2 or 3, wherein the source is configured to drive each of one or more of the second emitter elements to emit charged particles exclusively during the cleaning periods.

**6.** The source of any preceding claim, wherein at least a portion of the target surface is in a direct line of sight of one or more of the second emitter elements.

**7.** The source of any preceding claim, wherein the first emitter element defines an emitting surface, the source being configured to cause the assessment charged particles to be emitted from the emitting surface, optionally the target surface comprises at least a portion of the emitting surface.

**8.** The source of claim 7, wherein the target surface comprises a surface of the source outside of the emitting surface, desirably said surface of the source consisting of a material liable to outgas.

**9.** The source of any preceding claim, wherein the one or more second emitter elements comprises a plurality of the second emitter elements.

**10.** The source of any preceding claim, configured such that one or more of the cleaning periods is while a pressure at the first emitter element is above an assessment pressure at which the assessment beam apparatus is configured to project the beam of charged particles towards the sample for assessing the sample.

**11.** The source of any preceding claim, configured such that one or more of the cleaning periods is while a pressure at the first emitter element is at an assessment pressure at which the assessment apparatus is configured to project the beam of charged particles towards the sample for assessing the sample.

**12.** The source of any preceding claim, configured to apply a potential difference between the first emitter element and the or each of the one or more second emitter elements, at least during the cleaning periods, the potential difference being such as to drive the cleaning charged particles towards at least a portion of the first emitter element.

**13.** An assessment apparatus for assessing a sample by projecting a beam of charged particles towards the sample, the assessment apparatus comprising:
the source of any of claims 1 to 211;
a sample support configured to support the sample;
a charged particle-optical device configured to project the beam of charged particles from the source towards the sample; and
a vacuum chamber containing at least the charged particle-optical device and the source.

**14.** The apparatus of claim 13, wherein the target surface comprises a surface in the charged particle-optical device, optionally a surface of a charged particle-optical element of the charged particle-optical device.

**15.** A method of cleaning a charged particle source of an assessment apparatus, the source comprising a first emitter element and one or more second emitter elements, the method comprising:
using the first emitter element to emit assessment charged particles and project a beam of charged particles comprising the assessment charged particles towards a sample to assess the sample; and
using the one or more second emitter elements to emit cleaning charged particles and causing the cleaning charged particles to impinge intermittently on a target surface of the assessment apparatus during a corresponding plurality of cleaning periods.
